(19) Europäisches Patentamt
European Patent Office
Office européen des brevets

(11) EP 4 766 035 A1
(12) **DEMANDE DE BREVET EUROPEEN**

(43) Date de publication:
**24.06.2026 Bulletin 2026/26**

(21) Numéro de dépôt: **25225178.0**

(22) Date de dépôt: **18.12.2025**

(51) Classification Internationale des Brevets (IPC):
**H05K 1/02** (2006.01)    H05K 3/00 (2006.01)

(52) Classification Coopérative des Brevets (CPC):
**H05K 1/0206;** H05K 1/0271; H05K 3/0047;
H05K 3/0094; H05K 2201/066; H05K 2201/0959;
H05K 2201/09772; H05K 2201/09781;
H05K 2201/09809

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité: **19.12.2024  FR 2414583**

(71) Demandeur: **THALES
92190 Meudon (FR)**

(72) Inventeurs:
• **MAUDET, Christian**
  **49309 CHOLET (FR)**
• **GUERN, Pierre**
  **49309 CHOLET (FR)**
• **RIBALET, Philippe**
  **49309 CHOLET (FR)**
• **MEILLERAIS, Nicolas**
  **49309 CHOLET (FR)**

(74) Mandataire: **Lavoix
2, place d'Estienne d'Orves
75441 Paris Cedex 09 (FR)**

(54) **CARTE DE CIRCUIT IMPRIMÉ, APPAREIL ÉLECTRONIQUE ET PROCÉDÉ DE FABRICATION ASSOCIÉS**

(57)     Cette carte (12) de circuit imprimé comprend un via (20), qui est ménagé au travers de la carte et qui comprend un premier fût (21), le premier fût étant réalisé en métal, étant configuré pour évacuer de la chaleur d'un composant électronique (16), par exemple un amplificateur de tension, et délimitant un premier volume interne (V21). Le via (20) comprend un deuxième fût (22), qui est différent du premier fût (21), qui est réalisé en métal et qui est reçu dans le premier volume interne (V21) coaxialement au premier fût (21). Le deuxième fût (22) est solidarisé au premier fût (21) au moyen d'une première résine polymère (32) et est configuré pour évacuer la chaleur générée par le composant électronique (16).

FIG.1

EP 4 766 035 A1

## Description

La présente invention concerne une carte de circuit imprimé, ainsi qu'un appareil électronique comprenant une telle carte de circuit imprimé. L'invention concerne également un procédé de fabrication d'une telle carte de circuit imprimé.

Dans le domaine des cartes de circuits imprimés, dites aussi PCB pour *« printed circuit board »* en anglais, certains composants électroniques montés en surface de la carte sont susceptibles de chauffer et exigent d'être refroidis. Les composants montés en surface sont aussi désignés par l'acronyme CMS, tandis que la technologie de montage en surface est connue sous l'acronyme SMT, de l'anglais *« surface mount technology »*.

Il est connu de placer dans le PCB un insert métallique, préférentiellement en cuivre, qui traverse le PCB, le composant étant monté sur une face du PCB au-dessus de l'insert, de sorte que l'insert évacue de la chaleur générée par le composant au travers du PCB. Un radiateur est généralement placé au contact de l'insert sur une face opposée du PCB. L'insert métallique présente cependant un coefficient de dilatation thermique très différent de celui du PCB, qui est généralement réalisé sous la forme de plusieurs couches de résine polymère, par exemple de la résine polyester ou de la résine époxy, pressées entre elles. À titre d'illustration, un PCB présente un coefficient de dilatation thermique, de l'ordre de $18 \times 10^{-6}$/K dans un plan parallèle au PCB, autrement dit pour un écart de température de 1 degré Kelvin, un PCB d'une longueur d'un mètre se dilate de 18 micromètres. Le coefficient de dilatation est aussi noté 18 ppm/°C. Le même PCB présente un coefficient de dilatation thermique « en Z », c'est-à-dire selon une direction orthogonale au plan du PCB, de l'ordre de 50 à $200 \times 10^{-6}$/K, tandis que le cuivre présente un coefficient de dilatation thermique isotrope de l'ordre de $17 \times 10^{-6}$/K. Ainsi le différentiel de dilatation thermique génère des contraintes thermomécaniques à l'intérieur du PCB, qui risque de présenter des fissures à l'interface entre l'insert en cuivre et le PCB.

Il est également connu de ménager des vias au travers du PCB. De manière générale, un via est formé par un perçage, ménagé au travers du PCB, qui est recouvert d'une couche de métal, notamment en cuivre, déposée par métallisation. On obtient ainsi un fût métallique, qui est ensuite, généralement, bouché au moyen d'une résine polymère. Typiquement, le perçage présente un diamètre de plusieurs centaines de microns, par exemple 300 $\mu$m, tandis que l'épaisseur de la couche de métal est typiquement de l'ordre de 18 à 25 $\mu$m, voire jusqu'à 30 $\mu$m. Les documents US-2004/149490-A1 et US-2023/262893-A1 décrivent chacun des vias concentriques, destinés notamment à la protection électromagnétique.

Ainsi, un ou plusieurs vias sont ménagés sous le composant à refroidir, en fonction de la traille du composant ou des contraintes d'encombrement. Grâce à l'épaisseur relativement réduite de métal, les vias n'engendrent pas ou peu de contraintes thermomécaniques liées à la dilatation thermique. Cependant, l'efficacité de l'évacuation de chaleur est limitée par la faible épaisseur du métal.

C'est à ces problèmes qu'entend plus particulièrement remédier l'invention, en proposant une carte de circuit imprimé présentant une capacité améliorée de refroidissement des composants montés en surface, sans toutefois générer de contraintes thermomécaniques.

À cet effet, l'invention concerne une carte de circuit imprimé, dans laquelle :

- la carte présente deux faces opposées, les deux faces opposées incluant une face haute et une face basse et étant orthogonales à un axe de hauteur,
- la carte comprend un via, qui est ménagé au travers de la carte et qui s'étend selon un axe principal parallèle à l'axe de hauteur,
- le via comprend un premier fût, qui est réalisé en métal, qui s'étend selon l'axe principal et qui présente une extrémité haute, qui affleure sur la face haute, et une extrémité basse, qui est située à l'opposé de l'extrémité haute selon l'axe principal,
- le premier fût est configuré pour évacuer de la chaleur d'un composant électronique, par exemple un amplificateur de tension, lorsque le composant électronique est fixé sur la face haute en appui contre l'extrémité haute du premier fût et est en fonctionnement,
- le via comprend un deuxième fût, qui est différent du premier fût, qui est réalisé en métal et qui est agencé dans un premier volume interne du premier fût coaxialement au premier fût, le deuxième fût présentant une extrémité haute, qui affleure la face haute de la carte, et une extrémité basse opposée à l'extrémité haute,
- le deuxième fût est solidarisé au premier fût au moyen d'une première résine polymère,
- le deuxième fût est configuré pour évacuer la chaleur générée par le composant électronique en fonctionnement,
- le deuxième fût délimite un deuxième volume interne, qui est obturé par une deuxième résine polymère,

   alors que la carte présente une première surface métallisée, qui s'étend sur une portion de la face haute et qui relie l'extrémité haute du premier fût à l'extrémité haute du deuxième fût,
   et que la première surface métallisée est propre au contact avec un composant électronique, de manière à transmettre une partie de la chaleur générée par le composant électronique en fonctionnement conjointement au premier fût et au deuxième fût.

Grâce à l'invention, deux fûts de métal coaxiaux contribuent conjointement à l'évacuation de la chaleur générée par les composants montés en surface. En coupe orthogonalement à l'axe principal, les deux fûts concentriques présentent une quantité de métal, rapportée à la surface du PCB, significativement supérieure à ce qu'il est possible d'atteindre en ménageant des vias simples, même lorsque ces vias sont le plus resserrés possibles.

À titre d'exemple, dans une surface d'échange carrée de surface A, il est possible de positionner quatre vias ayant une pastille de diamètre D et tangents par leurs pastilles à la pastille de même diamètre D d'un cinquième via positionné au centre du carré de la surface d'échange. Cette configuration géométrique associe le côté C du carré à la surface A de celui-ci tel que $C = \sqrt{A}$ . Une telle surface contient deux fûts métalliques. Les diamètres de pastilles sont tels que

$$D = \frac{C}{\sqrt{2}} = \frac{\sqrt{A}}{\sqrt{2}}$$ . La densité de cuivre obtenue par la section des fûts des vias dans une unité de surface carré évolue selon le diamètre de la pastille du via. Dans l'hypothèse où l'épaisseur de cuivre dans le fût est de 25 μm et que le diamètre percé du fût est 300 μm inférieur au diamètre de la pastille, cette densité croit jusqu'à ~3,1% de cuivre pour les petits diamètres de pastille, puis décroit pour les diamètres supérieurs à 650 μm jusqu'à atteindre 2,0% de cuivre lorsque la pastille atteint un diamètre de 1,5 mm. Dans la configuration où deux fûts sont imbriqués tel que le diamètre percé du fût extérieur soit le diamètre de la pastille du fût intérieur, la densité de cuivre par unité de surface d'échange atteint un maximum de 4,25 % avec un diamètre de pastille pour le fût extérieur de 925 μm. Ceci constitue un gain sur la densité de cuivre de 35 %. Le transfert d'énergie thermique est ainsi amélioré.

En outre, chaque fût est rempli de résine, qui présente un coefficient de dilatation thermique similaire, voire identique, à celui du reste du PCB. Ainsi les deux fûts coaxiaux n'engendrent pas de contrainte thermomécanique lorsque la température du PCB varie au cours de son utilisation.

Selon des aspects avantageux mais non obligatoires de l'invention, une telle carte de circuit imprimé peut incorporer une ou plusieurs des caractéristiques suivantes prises isolément ou selon toute combinaison techniquement admissible :

- L'extrémité basse du premier fût et l'extrémité basse du deuxième fût sont situées dans un même plan orthogonal à l'axe principal.
- L'extrémité basse du premier fût affleure la face basse de la carte.
- Le deuxième fût délimite un deuxième volume interne, qui est obturé par une deuxième résine polymère,

alors que la carte présente une deuxième surface métallisée, qui s'étend sur la face basse et qui relie l'extrémité basse du premier fût à l'extrémité basse du deuxième fût, et que la deuxième surface métallisée est propre au contact avec un composant radiateur, de manière à refroidir le premier fût et le deuxième fût.

- La première résine polymère et/ou la deuxième résine polymère présentent une conductivité thermique supérieure à 2 W/mK.
- La carte comprend un composant électronique, par exemple un amplificateur de tension, qui est monté sur la face haute de la carte, le composant électronique étant en contact conjointement avec l'extrémité haute du premier fût et avec l'extrémité haute du deuxième fût.

L'invention concerne aussi un appareil électronique, comprenant une carte telle que décrite précédemment.

Selon un autre aspect, l'invention concerne un procédé de fabrication d'une carte de circuit imprimé telle que décrite précédemment, le procédé incluant les étapes suivantes :

- une étape de fourniture de la carte de circuit imprimé,
- ensuite, une première étape de perçage, au cours de laquelle on perce la carte selon l'axe de hauteur, de manière à former un premier trou débouchant sur la face haute,
- ensuite, une première étape de métallisation, au cours de laquelle on métallise le premier trou, de manière à former le premier fût, le premier fût délimitant un premier volume interne sensiblement cylindrique centré sur l'axe principal, une extrémité haute du premier fût affleurant la face haute,
- ensuite, une première étape de comblement, au cours de laquelle on comble le premier volume interne au moyen d'une première résine polymère,
- ensuite, une deuxième étape de perçage, au cours de laquelle on perce le premier volume interne comblé par la première résine polymère, de manière à former un deuxième trou, le deuxième trou présentant un diamètre inférieur à un diamètre du premier volume interne et débouchant sur la face haute,
- ensuite, une deuxième étape de métallisation, au cours de laquelle on métallise le deuxième trou, de manière à former le deuxième fût coaxial au premier fût, une extrémité haute du deuxième fût affleurant la face haute,
- une deuxième étape de comblement, au cours de laquelle on comble un deuxième volume interne délimité par le deuxième fût, au moyen d'une deuxième résine polymère, la deuxième étape de comblement étant postérieure à la deuxième étape de métallisation,

- ensuite, une troisième étape de métallisation, qui est postérieure à la deuxième étape de comblement, au cours de laquelle une portion de la face haute est métallisée, de manière à former une première surface métallisée reliant l'extrémité haute du premier fût à l'extrémité haute du deuxième fût.

Ce procédé induit les mêmes avantages que ceux mentionnés ci-dessus au sujet de la carte électronique de l'invention.

Avantageusement, au cours de la première étape de métallisation, une extrémité basse du premier fût affleure la face basse,

alors qu'au cours de la deuxième étape de métallisation, une extrémité basse du deuxième fût affleure la face basse,

et que le procédé comprend une quatrième étape de métallisation, qui est postérieure à la deuxième étape de comblement, au cours de laquelle une portion de la face basse est métallisée, de manière à former une deuxième surface métallisée reliant l'extrémité basse du premier fût à l'extrémité basse du deuxième fût.

L'invention sera mieux comprise, et d'autres avantages de celle-ci apparaîtront plus clairement à la lumière de la description qui va suivre, de plusieurs modes de réalisation d'une carte électronique, d'un appareil électronique et d'un procédé de fabrication, conformes à son principe, donnée uniquement à titre d'exemple et faite en référence aux dessins annexés, dans lesquels :

- [Fig 1] la figure 1 représente respectivement, sur deux inserts a) et b), une vue en perspective et une coupe d'un appareil électronique conforme à un premier mode de réalisation de l'invention, l'appareil électronique comprenant une carte de circuit imprimé elle-aussi conforme au premier mode de réalisation de l'invention ;
- [Fig 2] la figure 2 représente, sur quatre inserts a) à d), des étapes de fabrication de la carte de circuit imprimé de la figure 1 ;
- [Fig 3] la figure 3 représente, sur quatre inserts a) à d), d'autres étapes de fabrication de la carte de circuit imprimé de la figure 1, et
- [Fig 4] la figure 4 représente une vue de dessus d'une carte électronique conforme à un deuxième mode de réalisation de l'invention.

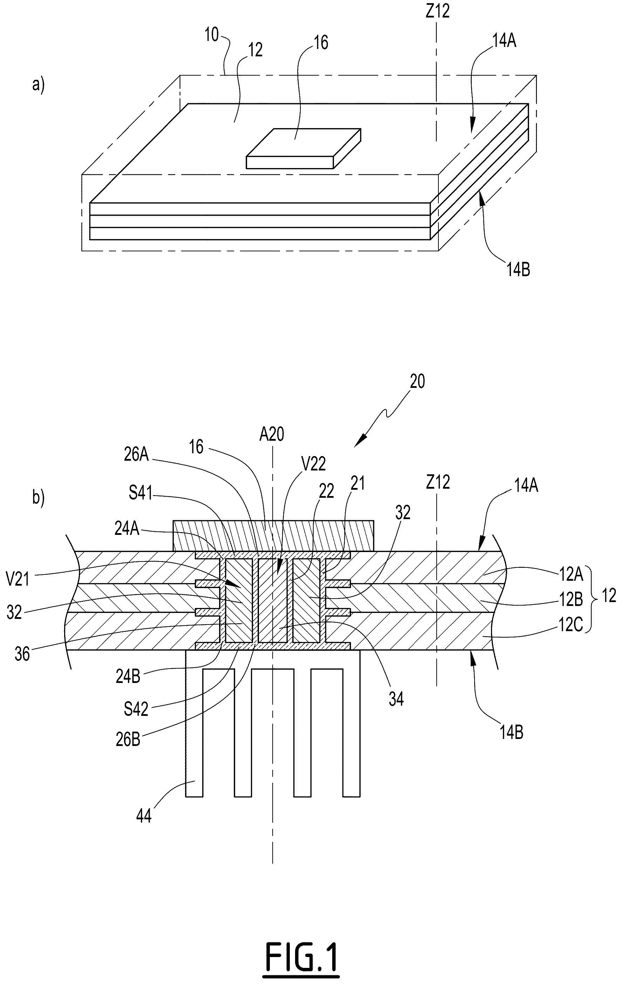

Un premier mode de réalisation de l'invention est décrit en référence aux figures 1 à 3. Un appareil électronique 10 est représenté à la figure 1 a). L'appareil électronique 10 est représenté schématiquement par un parallélépipède en traits mixtes. L'appareil électronique 10 comprend une carte 12. La carte 12 est une carte de circuit imprimé, ou PCB. La carte 12 présente deux faces opposées, les deux faces opposées incluant une face haute 14A et une face basse 14B et étant orthogonales à un axe de hauteur Z12. De manière générale, les notions de « haut », « bas », « droite », « gauche », sont données en relation avec l'orientation des éléments tels qu'illustrés sur les dessins, sachant qu'il peut en être autrement dans la réalité.

De manière connue, la carte 12 est formée par pressage de plusieurs couches de substrat isolant les unes sur les autres, des couches métalliques, en particulier du cuivre, étant situées sur des faces des couches de substrat. Les couches métalliques sont gravées de manière à former des circuits imprimés. Les circuits imprimés à la surface des couches de substrat ne sont pas représentés. Il est connu de ménager des connexions électriques entre les circuits imprimés au travers des couches de substrat en ménageant des perçages métallisés appelés « vias ». Ainsi un via se présente généralement sous la forme d'un fût métallique, qui traverse une ou plusieurs couches de substrat selon l'axe de hauteur.

Dans l'exemple illustré, la carte 12 est formée par laminage de trois couches 12A, 12B et 12C de substrats, ce nombre n'étant pas limitatif, sachant que l'invention peut être mise en œuvre pour une carte de circuit imprimé monocouche (d'un point de vue substrat) aussi bien que pour une carte multicouche.

La carte 12 comprend un composant électronique 16, par exemple ici un amplificateur de tension, qui est monté sur la face haute 14A de la carte 12. Le composant électronique 16 est ainsi un composant monté en surface, dit aussi CMS, de manière à être connecté au circuit imprimé situé sur la face haute 14A.

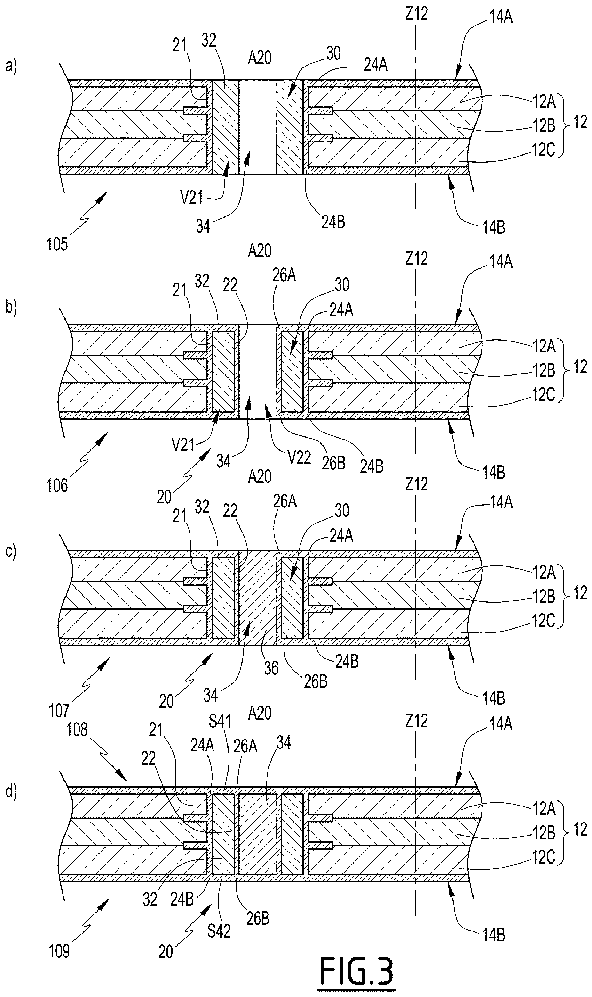

Lorsque l'appareil électronique 10 est en fonctionnement normal, le composant électronique 16 dégage de la chaleur, qu'il convient d'évacuer. À cette fin, un via 20 est ménagé au travers de la carte 12. Le via 20 est visible en coupe à la figure 3 d). Le via 20 s'étend selon un axe principal A20 qui est parallèle à l'axe de hauteur Z12.

Le via comprend un premier fût 21, qui s'étend selon l'axe principal A20, et qui est réalisé en métal. Le premier fût 21 est réalisé par perçage de la carte 12, de préférence au moyen d'un foret, le trou ainsi réalisé étant ensuite métallisé pour former le premier fût 21. La métallisation permet de déposer une couche de métal, de préférence du cuivre, présentant une épaisseur généralement comprise entre 18 $\mu$m et 30 $\mu$m. La métallisation se fait par exemple par dépôt électrochimique. Le premier fût 21 présente ainsi une forme sensiblement cylindrique avec une section circulaire. Le premier fût 21 présente une extrémité haute 24A, qui affleure sur la face haute 14A de la carte 12, et une extrémité basse 24B qui affleure sur la face 14B, qui est située à l'opposé de l'extrémité haute 24A selon l'axe principal A20. L'extrémité basse 24B est ainsi située du côté de la face basse 14B. Le premier fût 21 délimite un premier volume interne V21, qui relie la face haute 14A à la face basse 14B au travers de la carte 12. On comprend que le premier volume interne V21 correspond sensiblement au premier trou 30, diminué du premier fût 21.

Le premier fût 21 est configuré pour évacuer une partie de la chaleur générée par le composant électronique 16 en fonctionnement, le composant électronique 16 étant monté en appui contre l'extrémité haute 24A du premier fût 21.

Le via 20 comprend un deuxième fût 22, qui est différent du premier fût 21, qui est réalisé en métal et qui est agencé dans le premier volume interne V21 coaxialement au premier fût 21. Le deuxième fût 22 est solidarisé au premier fût 21 au moyen d'une première résine polymère 32, qui comble une portion du premier volume interne V21 située entre le deuxième fût 22 et le premier fût 21. Le deuxième fût 22 présente une forme sensiblement cylindrique avec une section circulaire. Le deuxième fût 22 présente une extrémité haute 26A, qui affleure la face haute 14A de la carte 12, et une extrémité basse 26B opposée à l'extrémité haute 26A. Le deuxième fût 22 est configuré pour évacuer une partie de la chaleur générée par le composant électronique 16 en fonctionnement, le composant électronique 16 étant monté en appui contre l'extrémité haute 26A du deuxième fût 22.

Ainsi on comprend que le premier fût 21 et le deuxième fût 22 contribuent conjointement à évacuer une partie de la chaleur générée par le composant électronique 16 en fonctionnement.

Dans l'exemple illustré, le deuxième fût 22 est également rempli de résine polymère 32 afin de fournir un support à la couverture cuivre de l'ensemble de la surface utilisée pour le transfert de chaleur ou pour des considérations d'assemblage du composant 16. En variante non illustrée, le deuxième fût 22 n'est pas rempli de résine polymère.

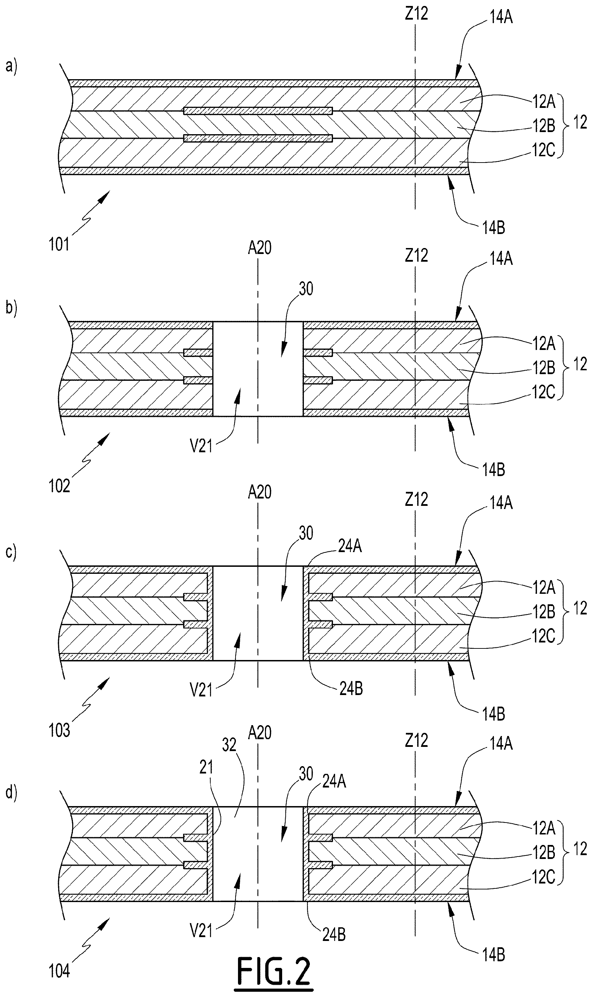

On décrit à présent un procédé de fabrication du via 20, en référence aux figures 2 et 3.

Le procédé comprend une étape de fourniture 101 de la carte 12 de circuit imprimé, comme illustré à la figure 2 a).

Ensuite, le procédé comprend une première étape de perçage 102, au cours de laquelle on perce la carte 12 selon l'axe de hauteur Z12, de manière à former un premier trou 30 débouchant sur la face haute 14A comme illustré à la figure 2 b). En pratique, le premier trou 30 est percé au moyen d'un foret. Le premier trou 30 présente typiquement un diamètre compris entre 500 $\mu$m et 1100 $\mu$m. Le premier trou 30 présente une forme globalement cylindrique avec une section circulaire centrée sur l'axe principal A20.

Ensuite, le procédé comprend une première étape de métallisation 103, au cours de laquelle on métallise le premier trou 30, de manière à former le premier fût 21, comme illustré à la figure 2 c). Le premier fût 21 délimite le premier volume interne V21, qui est sensiblement cylindrique et centré sur l'axe principal A20. La première étape de métallisation 103 permet d'appliquer une épaisseur de métal allant typiquement de 20 à 30 $\mu$m. On comprend que le premier volume interne V21 correspond alors sensiblement au trou 30, diminué de l'épaisseur de métal du fût 21. L'extrémité haute 24A du premier fût 21 affleure la face haute 14A de la carte 12. De préférence, l'extrémité basse 24B du premier fût 21 affleure la face basse 14B de la carte 12.

Ensuite, le procédé comprend une première étape de comblement 104, au cours de laquelle on comble le premier volume interne V21 au moyen d'une première résine polymère 32. Selon des exemples non limitatifs, la première résine polymère 32 est par exemple une résine époxy. Après durcissement, la résine polymère 32 forme un bouchon solide, qui obture le premier volume interne V21, comme illustré à la figure 2 d).

Ensuite, le procédé comprend une deuxième étape de perçage 105, au cours de laquelle on perce le premier volume interne V21 préalablement comblé par la première résine polymère 32, de manière à former un deuxième trou 34, le deuxième trou 34 présentant un diamètre inférieur à un diamètre du premier volume interne V21 et débouchant sur la face haute 14A, comme illustré à la figure 3 a). De préférence, le deuxième trou 34 est centré sur l'axe principal A20. De préférence, le perçage du premier volume interne V21 est réalisé au moyen d'un foret. Selon une alternative non illustrée, le perçage du premier volume interne V21 est fait au moyen d'un laser, cette méthode étant classiquement utilisée pour ménager des vias de petits diamètres appelés « micro-vias ».

Ensuite, le procédé comprend une deuxième étape de métallisation 106, au cours de laquelle on métallise le deuxième trou 34, de manière à former le deuxième fût 22, comme illustré à la figure 3 b). Le deuxième fût 22 délimite un deuxième volume interne V22. On comprend que le deuxième volume interne V22 correspond sensiblement au deuxième trou 34, diminué d'une épaisseur du deuxième fût 22.

De préférence, le deuxième fût 22 est coaxial au premier fût 21, l'extrémité haute 26A du deuxième fût 22 affleurant la face haute 14A de la carte 12. Autrement dit, les extrémités hautes 26A et 24A du deuxième fût 22 et du premier fût 21 affleurent la face haute 14A de la carte 12, de sorte que lorsque le composant électronique 16 est assemblé sur la carte 12, le composant électronique 16 est au contact avec les premier et deuxième fûts 21 et 22, favorisant les échanges thermiques. On obtient ainsi le via 20.

En référence à la figure 3 c), le procédé comprend avantageusement une deuxième étape de comblement 107, qui est postérieure à la deuxième étape de métallisation 106 et au cours de laquelle on comble le deuxième volume interne V22, au moyen d'une deuxième résine polymère 36. Après durcissement, la deuxième résine polymère 36 forme un bouchon solide, qui obture le deuxième volume interne V22.

Ensuite, en référence à la figure 3 d), le procédé comprend avantageusement une troisième étape de métallisation 108, au cours de laquelle on métallise une portion de la face haute 14A de la carte 12, de manière à relier l'extrémité haute 24A du premier fût 21 à l'extrémité haute 26A du deuxième fût 22.

En résultat, la carte 12 présente avantageusement une première surface métallisée S41, qui s'étend sur une portion de la face haute 14A et qui relie l'extrémité haute 24A du premier fût 21 à l'extrémité haute 26A du deuxième fût 22. De préférence, la première surface métallisée S41 recouvre au moins, sur la face haute 14A, le premier volume interne V21. La première surface métallisée S41 est propre au contact avec le composant électronique 16, de manière à transmettre une partie de la chaleur générée par le composant électronique 16 en fonctionnement conjointement au premier fût 21 et au deuxième fût 22.

De manière analogue, le procédé comprend avantageusement une quatrième étape de métallisation 109, qui est postérieure à la deuxième étape de comblement 107 et au cours de laquelle on métallise une portion de la face basse 14B, de manière à former une deuxième surface métallisée S42 reliant l'extrémité basse 24B du premier fût 21 à l'extrémité basse 26B du deuxième fût 22. De préférence, les étapes de troisième métallisation 108 et de quatrième métallisation 109 sont simultanées.

En résultat, la carte 12 présente avantageusement la deuxième surface métallisée S42, qui s'étend sur une portion de la face basse 14B et qui relie l'extrémité basse 24B du premier fût 21 à l'extrémité basse 26B du deuxième fût 22. De préférence, la deuxième surface métallisée S42 recouvre au moins, sur la face basse 14B, le premier volume interne V21. La deuxième surface métallisée S42 est propre au contact avec un composant radiateur 44, de manière à refroidir le premier fût 21 et le deuxième fût 22. Le composant radiateur 44 est représenté à la figure 1 b). On comprend que pour la mise en place de la deuxième surface métallisée S42, il convient que l'extrémité basse 24B du premier fût 21 et que l'extrémité basse 26B du deuxième fût 22 soient situées dans un même plan orthogonal à l'axe principal A20, et de préférence affleurent la face basse 14B de la carte 12.

De préférence, la première résine polymère 32 et/ou la deuxième résine polymère 36 sont des résines thermiquement conductrices. Par exemple, des charges thermiquement conductrices sont ajoutées aux résines, de manière à améliorer la conductivité thermique du matériau. De manière non limitative, les charges conductrices incluent des poudres métalliques, de préférence de cuivre, et/ou des fibres de carbone.

À titre d'illustration, une résine époxy classique présente une conductivité thermique de l'ordre de 0,2 W/m·K - Watt par mètre-Kelvin-. Une résine époxy thermiquement conductrice présente une conductivité thermique allant de 2 à 5 W/m·K. À titre de comparaison, le cuivre présente une conductivité thermique de l'ordre de 380 W/m·K. Dans le cadre de la présente application, on considère qu'une résine polymère est thermiquement conductrice lorsque sa conductivité thermique est supérieure à 2 W/m·K.

Dans le cadre de l'invention, il n'est pas nécessaire que les première ou deuxième résines polymères 32 / 36 soient électriquement isolantes. Il est ainsi possible de modifier les première ou deuxième résines polymères 32 / 36 selon les besoins, tant que les résistances mécaniques restent acceptables au vu de l'application envisagée, et tant qu'un coefficient de dilatation thermique des première ou deuxième résines polymères 32 / 36, une fois durcies, reste sensiblement égal à un coefficient de dilatation thermique de la carte 12 selon l'axe de hauteur Z12. Par sensiblement égal, on entend du même ordre de grandeur.

De préférence, la deuxième résine polymère 36 utilisée lors de la deuxième étape de comblement 107 est similaire, voire identique, a la première résine polymère 32 utilisée lors de la première étape de comblement 104.

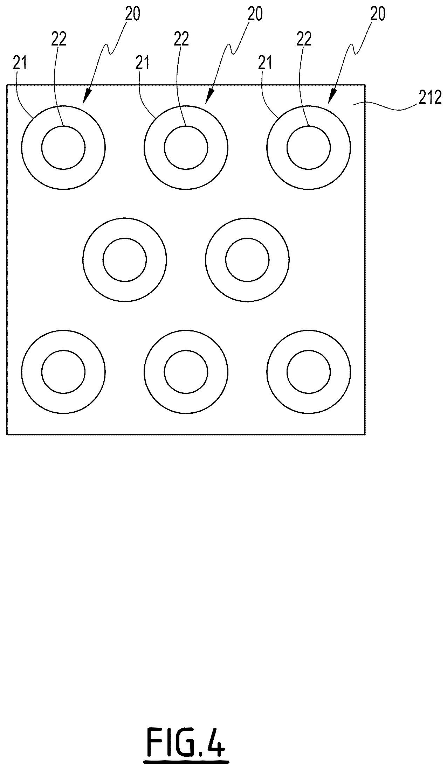

Une carte 212 de circuit imprimé, conforme à un deuxième mode de réalisation de l'invention, est représentée en figure 4. Dans le deuxième mode de réalisation, les éléments analogues à ceux du premier mode de réalisation portent les mêmes références et fonctionnent de la même façon. Dans ce qui suit, on décrit principalement les différences entre les premier et deuxième modes de réalisation.

Alors que dans le premier mode de réalisation, la carte 12 comprend un seul via 20, qui comprend deux fûts coaxiaux, à savoir le premier fût 21 et le deuxième fût 22, dans le deuxième mode de réalisation, la carte 212 comprend plusieurs vias 20, qui comprennent chacun le premier fût 21 et le deuxième fût 22. Dans l'exemple illustré, les vias 20 sont avantageusement agencés en quinconce, ce qui permet de maximiser la quantité surfacique du cuivre, tout en préservant un écartement minimal entre chaque via pour respecter les contraintes de fabrication. Il est possible de réduire l'espacement de sorte à rendre les pastilles des vias 20 tangentes les unes aux autres.

À titre d'exemple comparatif, lorsque des vias selon l'état de la technique sont ménagés sur une carte de circuit imprimé pour évacuer de la chaleur des composants électroniques montés en surface, typiquement des vias de 300 μm sont ménagés en quinconce, avec un pas entre les vias de 650 μm. Cela représente une « densité surfacique de trous » de 2,73 trous / mm$^2$. En considérant que chaque via comprend un unique fût présentant une épaisseur de l'ordre de 20 μm, cela se traduit par une densité surfacique de cuivre de 4,8 %.

Selon un exemple conforme à l'invention, les vias sont ménagés en quinconce selon un pas de 900 μm, ce qui présente une « densité surfacique de trous » de 1,28 trou / mm$^2$. Pour chaque via, le premier fût 21 présente un diamètre de 600 μm, et le deuxième fût présente un diamètre de 300 μm, les deux fûts 21/22 présentant une épaisseur de 20 μm. Dans ces conditions, on obtient une densité surfacique de cuivre de 6,9 %, soit une augmentation de 44 % par rapport à la situation selon l'art antérieur. Le gain en conduction thermique progresse d'autant, de 44 %. En outre, l'épaisseur de cuivre des fûts, typiquement de 20 à 30 μm,

est suffisamment réduite pour que les fûts n'aient pas d'impact notable sur le coefficient de dilatation thermique du via 20/220 selon l'axe de hauteur Z12. Il est bien entendu possible de fabriquer des fûts plus épais, tant que les coefficients de dilatation thermique en Z des vias ainsi fabriqués restent sensiblement égaux au coefficient de dilation thermique en Z de la carte 12. L'étape de métallisation prendra cependant plus de temps, renchérissant le coût de fabrication.

Dans les deux modes de réalisation illustrés, chaque via 20 / 220 comprend deux fûts coaxiaux.

En variante non illustrée, chaque via comprend trois fûts métalliques coaxiaux, voire plus. On comprend que ménager trois fûts coaxiaux représente un coût supplémentaire en termes de temps de fabrication et/ou de coût, cependant un tel agencement à trois fûts coaxiaux peut se révéler avantageux pour refroidir localement un composant électronique de petite dimension.

Les modes de réalisation et les variantes mentionnées ci-dessus peuvent être combinés entre eux pour générer de nouveaux modes de réalisation de l'invention.

## Revendications

1. Carte (12 ; 212) de circuit imprimé, dans laquelle :

   - la carte (12 ; 212) présente deux faces opposées, les deux faces opposées incluant une face haute (14A) et une face basse (14B) et étant orthogonales à un axe de hauteur (Z12),
   - la carte (12 ; 212) comprend un via (20), qui est ménagé au travers de la carte (12 ; 212) et qui s'étend selon un axe principal (A20) parallèle à l'axe de hauteur (Z12),
   - le via (20) comprend un premier fût (21), qui est réalisé en métal, qui s'étend selon l'axe principal (A20) et qui présente une extrémité haute (24A), qui affleure sur la face haute (14A), et une extrémité basse (24B), qui est située à l'opposé de l'extrémité haute (24A) selon l'axe principal (A20),
   - le premier fût (21) est configuré pour évacuer de la chaleur d'un composant électronique (16), par exemple un amplificateur de tension, lorsque le composant électronique (16) est fixé sur la face haute (14A) en appui contre l'extrémité haute (24A) du premier fût (21) et est en fonctionnement,
   - le via (20) comprend un deuxième fût (22), qui est différent du premier fût (21), qui est réalisé en métal et qui est agencé dans un premier volume interne (V21) du premier fût (21) coaxialement au premier fût (21), le deuxième fût (22) présentant une extrémité haute (26A), qui affleure la face haute (14A) de la carte (12 ; 212), et une extrémité basse (26B) opposée à l'extrémité haute,
   - le deuxième fût (22) est solidarisé au premier fût (21) au moyen d'une première résine polymère (32),
   - le deuxième fût (22) est configuré pour évacuer la chaleur générée par le composant électronique (16) en fonctionnement,
   - le deuxième fût (22) délimite un deuxième volume interne (V22), qui est obturé par une deuxième résine polymère (36),
   - la carte (12 ; 212) présente une première surface métallisée (S41), qui s'étend sur une portion de la face haute (14A) et qui relie l'extrémité haute (24A) du premier fût (21) à l'extrémité haute (26A) du deuxième fût (22),
   - la première surface métallisée (S41) est propre au contact avec un composant électronique (16), de manière à transmettre une partie de la chaleur générée par le composant électronique (16) en fonctionnement conjointement au premier fût (21) et au deuxième fût (22).

2. Carte (12 ; 212) selon la revendication 1, dans laquelle :

   - l'extrémité basse (24B) du premier fût (21) et l'extrémité basse (26B) du deuxième fût (22) sont situées dans un même plan orthogonal à l'axe principal (A20).

3. Carte (12 ; 212) selon la revendication 2, dans laquelle :

   - l'extrémité basse (24B) du premier fût (21) affleure la face basse (14B) de la carte (12 ; 212).

4. Carte (12 ; 212) selon la revendication 3, dans laquelle :

   - le deuxième fût (22) délimite un deuxième volume interne (V22), qui est obturé par une deuxième résine polymère (36),
   - la carte (12 ; 212) présente une deuxième surface métallisée (S42), qui s'étend sur la face basse (14B) et qui relie l'extrémité basse (24B) du premier fût (21) à l'extrémité basse (26B) du deuxième fût (22),
   - la deuxième surface métallisée (S42) est propre au contact avec un composant radiateur, de manière à refroidir le premier fût (21) et le deuxième fût (22).

5. Carte (12 ; 212) selon la revendication 4, dans laquelle :

   - la première résine polymère (32) et/ou la deuxième résine polymère (36) présentent une conductivité thermique supérieure à 2 W/m·K.

**6.** Carte (12 ; 212) selon l'une quelconque des revendications 1 à 5, dans laquelle :

- la carte (12 ; 212) comprend un composant électronique (16), par exemple un amplificateur de tension, qui est monté sur la face haute (14A) de la carte (12 ; 212), le composant électronique (16) étant en contact conjointement avec l'extrémité haute (24A) du premier fût (21) et avec l'extrémité haute (26A) du deuxième fût (22).

**7.** Appareil électronique (10), comprenant une carte (12 ; 212) selon la revendication 6.

**8.** Procédé de fabrication d'une carte (12 ; 212) de circuit imprimé, le procédé incluant les étapes suivantes :

- une étape de fourniture (101) de la carte (12 ; 212) de circuit imprimé,
- ensuite, une première étape de perçage (102), au cours de laquelle on perce la carte (12 ; 212) selon l'axe de hauteur (Z12), de manière à former un premier trou (30) débouchant sur la face haute (14A),
- ensuite, une première étape de métallisation (103), au cours de laquelle on métallise le premier trou (30), de manière à former le premier fût (21), le premier fût (21) délimitant un premier volume interne (V21) sensiblement cylindrique centré sur l'axe principal (A20), une extrémité haute du premier fût (21) affleurant la face haute (14A),
- ensuite, une première étape de comblement (104), au cours de laquelle on comble le premier volume interne (V21) au moyen d'une première résine polymère (32),
- ensuite, une deuxième étape de perçage (105), au cours de laquelle on perce le premier volume interne (V21) comblé par la première résine polymère (32), de manière à former un deuxième trou (34), le deuxième trou présentant un diamètre inférieur à un diamètre du premier volume interne (V21) et débouchant sur la face haute (14A),
- ensuite, une deuxième étape de métallisation (106), au cours de laquelle on métallise le deuxième trou (34), de manière à former le deuxième fût (22) coaxial au premier fût (21), une extrémité haute (26A) du deuxième fût (22) affleurant la face haute (14A),
- une deuxième étape de comblement (107), au cours de laquelle on comble un deuxième volume interne (V22) délimité par le deuxième fût (22), au moyen d'une deuxième résine polymère (36), la deuxième étape (107) de comblement étant postérieure à la deuxième étape de métallisation (106),

- ensuite, une troisième étape de métallisation (108), qui est postérieure à la deuxième étape (107) de comblement, au cours de laquelle une portion de la face haute (14A) est métallisée, de manière à former une première surface métallisée (S41) reliant l'extrémité haute (24A) du premier fût (21) à l'extrémité haute (26A) du deuxième fût (22).

**9.** Procédé selon la revendication 8, dans lequel :

- au cours de la première étape (103) de métallisation, une extrémité basse (24B) du premier fût (21) affleure la face basse (14B),
- au cours de la deuxième étape (106) de métallisation, une extrémité basse (26B) du deuxième fût (22) affleure la face basse (14B),
- le procédé comprend une quatrième étape (109) de métallisation, qui est postérieure à la deuxième étape (107) de comblement, au cours de laquelle une portion de la face basse (14B) est métallisée, de manière à former une deuxième surface métallisée (S42) reliant l'extrémité basse (24B) du premier fût (21) à l'extrémité basse (26B) du deuxième fût (22).

$$\underline{FIG.1}$$

## FIG.2

## FIG.3

## FIG.4

Europäisches
Patentamt

European
Patent Office

Office européen
des brevets

**RAPPORT DE RECHERCHE EUROPEENNE**

Numéro de la demande

**EP 25 22 5178**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2004/149490 A1 (CHANG HUEY-RU [TW] ET AL) 5 août 2004 (2004-08-05)<br>* alinéa [0041] - alinéa [0043] *<br>* alinéa [0061] *<br>* alinéa [0047] *<br>* figures 6,13 *<br>----- | 1-9 | INV.<br>H05K1/02<br><br>ADD.<br>H05K3/00 |
| A | US 2023/262893 A1 (LU CHIH-CHIANG [TW] ET AL) 17 août 2023 (2023-08-17)<br>* alinéa [0097] - alinéa [0102] *<br>* figures 11,12 *<br>----- | 1-9 | |
| A | WO 2014/171004 A1 (MEIKO ELECTRONICS CO LTD [JP]) 23 octobre 2014 (2014-10-23)<br>* figures 6-9 *<br>----- | 1-9 | |
| A | US 2016/143126 A1 (TANEKO NORIAKI [JP] ET AL) 19 mai 2016 (2016-05-19)<br>* le document en entier *<br>----- | 1-9 | |
| A | US 2014/355213 A1 (BETTONI DAVIDE [IT] ET AL) 4 décembre 2014 (2014-12-04)<br>* le document en entier *<br>----- | 1-9 | DOMAINES TECHNIQUES RECHERCHES (IPC)<br><br>H05K |
| A | JP 2002 118385 A (TEKTRONIX INC) 19 avril 2002 (2002-04-19)<br>* le document en entier *<br>----- | 1-9 | |

Le présent rapport a été établi pour toutes les revendications

| Lieu de la recherche | Date d'achèvement de la recherche | Examinateur |
|---|---|---|
| La Haye | 27 mars 2026 | Cornelussen, Ronald |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

....................................................................................

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 25 22 5178

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-03-2026

| Document brevet cité au rapport de recherche | Date de publication | Membre(s) de la famille de brevet(s) | Date de publication |
|---|---|---|---|
| US 2004149490 A1 | 05-08-2004 | TW 525417 B<br>US 2002017399 A1<br>US 2004149490 A1 | 21-03-2003<br>14-02-2002<br>05-08-2004 |
| US 2023262893 A1 | 17-08-2023 | AUCUN | |
| WO 2014171004 A1 | 23-10-2014 | CN 105247968 A<br>JP 5873214 B2<br>JP WO2014171004 A1<br>KR 20150143578 A<br>TW 201513738 A<br>WO 2014171004 A1 | 13-01-2016<br>01-03-2016<br>16-02-2017<br>23-12-2015<br>01-04-2015<br>23-10-2014 |
| US 2016143126 A1 | 19-05-2016 | CN 104472022 A<br>EP 2836056 A1<br>JP 5456214 B1<br>JP WO2014199456 A1<br>KR 101466062 B1<br>TW 201501602 A<br>US 2016143126 A1<br>WO 2014199456 A1 | 25-03-2015<br>11-02-2015<br>26-03-2014<br>23-02-2017<br>27-11-2014<br>01-01-2015<br>19-05-2016<br>18-12-2014 |
| US 2014355213 A1 | 04-12-2014 | EP 2809135 A1<br>US 2014355213 A1 | 03-12-2014<br>04-12-2014 |
| JP 2002118385 A | 19-04-2002 | JP 3706317 B2<br>JP 2002118385 A<br>US 6477054 B1 | 12-10-2005<br>19-04-2002<br>05-11-2002 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2004149490 A1

- US 2023262893 A1